# EUROPÄISCHE PATENTSCHRIFT

(11) **EP 4 055 838 B1**
(45) Veröffentlichungstag und Bekanntmachung des Hinweises auf die Patenterteilung: **01.01.2025**
(21) Anmeldenummer: 19801504.2
(22) Anmeldetag: 04.11.2019
(51) Int. Cl.: H04R 25/00, H03G 3/32, H03G 7/00, H03G 9/00, H03G 9/18

(54) **VERFAHREN ZUM BETRIEB EINES HÖRSYSTEMS SOWIE HÖRSYSTEM**
METHOD FOR OPERATING A HEARING SYSTEM, AND HEARING SYSTEM
PROCÉDÉ DE FONCTIONNEMENT D'UN SYSTÈME AUDITIF ET SYSTÈME AUDITIF

(43) Veröffentlichungstag der Anmeldung: 14.09.2022
(73) Patentinhaber: Sivantos Pte. Ltd., Singapore 539775 (SG)
(72) Erfinder: BEST, Sebastian, 91054 Erlangen (DE); PILGRIM, Thomas, 91054 Erlangen (DE); WILSON, Cecil, 91058 Erlangen (DE)
(74) Vertreter: FDST Patentanwälte
(86) Internationale Anmeldenummer: PCT/EP2019/080089
(87) Internationale Veröffentlichungsnummer: WO 2021/089108

(56) Entgegenhaltungen:
- EP-A1- 2 908 550
- WO-A1-2019/215200
- US-A1- 2016 112 811
- US-A1- 2016 381 468
- US-B1- 6 198 830
- US-B2- 7 773 763
- KOWALEWSKI BORYS ET AL: "Effects of Fast-Acting Hearing-Aid Compression on Audibility, Forward Masking and Speech Perception", 2018 JOINT CONFERENCE - ACOUSTICS, IEEE, 11 September 2018 (2018-09-11), pages 1 - 9, XP033425731, DOI: 10.1109/ACOUSTICS.2018.8502390

## Beschreibung

Die Erfindung betrifft ein Verfahren zum Betrieb eines Hörsystems sowie ein entsprechendes Hörsystem.

Ein Hörsystem weist ist einer allgemeinsten Ausgestaltung eine Signalverarbeitung und einen Hörer auf, wobei der Hörer auch als Lautsprecher bezeichnet wird. Der Signalverarbeitung wird ein Eingangssignal zugeführt, welches dann durch die Signalverarbeitung modifiziert wird, sodass ein Ausgangssignal erzeugt wird, welches also ein modifiziertes Eingangssignal ist. Beispielsweise wird das Eingangssignal mit einem bestimmten Verstärkungsfaktor verstärkt. Im Folgenden werden das Eingangssignal und das Ausgangssignal allgemein jeweils auch als Signal bezeichnet. Das Ausgangssignal wird schließlich mittels des Hörers ausgegeben. Bei dem Eingangssignal und dem Ausgangssignal handelt es sich um elektrische Signale. Der Hörer wandelt dann das Ausgangssignal in ein Schallsignal um.

Optional weist das Hörsystem zusätzlich ein Mikrofon auf, welches das Eingangssignal erzeugt, indem ein oder mehrere Schallsignale aus der Umgebung aufgenommen werden und zu dem Eingangssignal umgewandelt werden. Ein solches Hörsystem mit einem zusätzlichen Mikrofon wird auch als Hörgerät bezeichnet und dient beispielsweise zur Versorgung einer hörgeschädigten Person, indem das Hörgerät genutzt wird, um Schallsignale aus der Umgebung zu verstärken und als verstärkte Schallsignale an die Person auszugeben.

Bei Hörsystemen ist es möglich, anstelle einer einfachen, linearen Verstärkung eine nicht-lineare Verstärkung durchzuführen. Dies wird beispielsweise mit einem sogenannten Kompressor realisiert, welcher ein Kompressionsschema bereitstellt und anwendet, welches bei der Modifizierung des Eingangssignals, also bei der Erzeugung des Ausgangssignals den Verstärkungsfaktor geeignet einstellt. Das Verhalten des Kompressors, d.h. das Kompressionsschema ist definiert durch einen oder mehrere Parameter, genauer Kompressionsparameter.

In der US 7,773,763 B2 wird ein Hörgerät beschrieben, bei welchem verschiedene Programme mit verschiedenen Umgebungstypen assoziiert sind. Jedes Programm enthält bestimmte Werte für bestimmte Parameter des Hörgeräts, um in einer gegebenen Umgebung eine optimale Signalqualität zu erzielen. Das Hörgerät kann die aktuelle Umgebung klassifizieren, einem Umgebungstyp zuordnen und dann ein geeignetes Programm mit entsprechend optimalen Parametern auswählen.

In der DE 10 2005 061 000 A1 wird ein Verfahren beschrieben, bei welchem abhängig von einem Klassifikationsergebnis zwischen zwei Kompressionsalgorithmen umgeschaltet wird.

In der DE 10 2010 041 740 A1 wird ein Verfahren beschrieben, bei welchem auf unterschiedlichen Frequenzbändern unterschiedliche Dynamikkompressionen ausgeführt werden.

In der US 6 198 830 B1 werden ein Verfahren zur Verstärkung von Eingangssignalen eines Hörgeräts sowie eine Schaltung zur Durchführung des Verfahrens beschrieben.

In der US 2016/381468 A1 wird ein Verfahren zur Kompression der Dynamik in einem Audio-Signal beschrieben.

In der EP 2 908 550 A1 wird ein Hörgerätevorrichtung mit Sensorelement beschrieben.

Vor diesem Hintergrund ist es eine Aufgabe der Erfindung, ein verbessertes Verfahren zum Betrieb eines Hörsystems sowie ein entsprechendes Hörsystems anzugeben. Insbesondere soll bei einem Hörsystem mit einer automatischen Verstärkungsregelung die Dynamik verbessert werden.

Die Aufgabe wird erfindungsgemäß gelöst durch ein jeweiliges Verfahren mit den Merkmalen gemäß Anspruch 1 und 2 sowie durch ein Hörsystem mit den Merkmalen gemäß Anspruch 14. Vorteilhafte Ausgestaltungen, Weiterbildungen und Varianten sind Gegenstand der Unteransprüche. Die Ausführungen im Zusammenhang mit dem Verfahren gelten sinngemäß auch für das Hörsystem und umgekehrt.

Das Verfahren dient zum Betrieb eines Hörsystems und ist somit ein Betriebsverfahren. Im Betrieb wird das Hörsystem von einem Nutzer getragen, insbesondere am, im oder hinter dem Ohr, also allgemein am Kopf und im Bereich eines oder beider Ohren. Zu einem gegebenen Zeitpunkt befinden sich das Hörsystem und der Nutzer in einer aktuellen akustischen Umgebung. Darunter wird verstanden, dass die Umgebung um den Nutzer und das Hörsystem herum zum aktuellen Zeitpunkt eine bestimmte akustische Kulisse bildet.

Das Hörsystem weist eine Signalverarbeitung auf, welche aus einem Eingangssignal des Hörsystems ein Ausgangssignal des Hörsystems erzeugt, indem das Eingangssignal mit einem Verstärkungsfaktor verstärkt wird. Die Signalverarbeitung wirkt also als ein Verstärker. Die Signalverarbeitung ist vorzugsweise in das Hörsystem integriert. Vorzugsweise ist das Hörsystem ein Hörgerät, besonders bevorzugt ein Hörgerät zur Versorgung einer hörgeschädigten Person. Als Hörgerät weist das Hörsystem zumindest ein Mikrofon auf, welches akustische Signale, also Schallsignale aus der Umgebung aufnimmt und in ein Eingangssignal umwandelt. Das Hörsystem weist weiter einen Hörer auf, über welchen das Ausgangssignal, also das verstärkte Eingangssignal ausgegeben wird. Der Hörer wird auch als Lautsprecher bezeichnet.

Der Verstärkungsfaktor wird durch eine automatische Verstärkungsregelung eingestellt, welche insbesondere ein Teil der Signalverarbeitung ist. Die automatische Verstärkungsregelung wird auch kurz als AGC (automatic gain control) bezeichnet. Unter "automatisch" wird insbesondere verstanden, dass keine Nutzereingabe erforderlich ist, um die Verstärkungsregelung durchzuführen, dies geschieht vielmehr selbststätig im Betrieb. Zusätzlich zur automatischen Verstärkungsregelung weist das Hörsystem in einer geeigneten Ausgestaltung noch eine manuelle Verstärkungssteuerung auf, über welche der Nutzer nach Belieben den Verstärkungsfaktor zusätzlich beeinflussen kann.

Die automatische Verstärkungsregelung weist einen Dynamikprozessor auf, welcher mit einem Dynamikschema betreibbar ist, welches den Verstärkungsfaktor als Funktion eines Pegels des Eingangssignals, also des Eingangspegels definiert. Das Dynamikschema gibt also an, bei welchem Eingangspegel welcher Verstärkungsfaktor verwendet wird. Das Dynamikschema wird auch als Dynamikalgorithmus bezeichnet. Beispiele für Dynamikschemata sind allgemein Kompressions- oder Expansionsschemata und speziell AGCi (automatic gain control input dependent) und ADRO (adaptive dynamic range optimization). Vorliegend sind diverse Dynamikschemata geeignet, besonders bevorzugt ist AGCi.

Ein Kennzeichen eines Dynamikprozessors ist nun, dass der Verstärkungsfaktor gerade nicht konstant ist, sondern dass der Dynamikprozessor zu einer nichtlinearen Verstärkung führt. Der Dynamikprozessor regelt insbesondere die Verstärkung durch die Signalverarbeitung in Abhängigkeit einer Regelgröße. Als Regelgröße wird beispielsweise der Eingangspegel verwendet oder alternativ der Ausgangspegel. Beide Varianten haben spezifische Vor- und Nachteile. Der jeweilige Pegel wird beispielsweise mittels eines Pegeldetektors gemessen, welcher zweckmäßigerweise ein Teil des Hörsystems ist.

Allgemein weisen das Eingangssignal und das Ausgangssignal jeweils eine Dynamik auf, d.h. einen Pegel, welcher innerhalb eines bestimmten Bereichs liegt, welcher von einem minimalen zu einem maximalen Pegel reicht. Der Pegel des Eingangssignals wird auch als Eingangspegel bezeichnet, der Pegel des Ausgangssignals entsprechend als Ausgangspegel. Analog wird die Dynamik des Eingangssignals als Eingangsdynamik bezeichnet, die Dynamik des Ausgangssignals als Ausgangsdynamik. Die Dynamik des Ausgangssignals ist abhängig von der Dynamik des Eingangssignals sowie von der Modifikation durch die Signalverarbeitung. In bestimmten Anwendungsfällen ist wünschenswert, die Dynamik des Ausgangssignals zu begrenzen, d.h. zu komprimieren, oder zu erhöhen, d.h. zu expandieren. Bei einem Hörgerät für eine hörgeschädigte Person wird die Dynamik zweckmäßigerweise an das gegenüber Normalhörenden reduzierte Hörvermögen der hörgeschädigten Person angepasst. Das reduzierte Hörvermögen beschränkt sich auf einen bestimmten Pegelbereich, welcher dann zweckmäßigerweise die Dynamik des Ausgangssignals definiert. Die Dynamik des Eingangssignals wird dann auf den Pegelbereich abgebildet, indem das Ausgangssignal mit einer entsprechend geeigneten Dynamik erzeugt wird, um insbesondere eine maximale Klangqualität zu erzielen. Je nach Ausgestaltung ist es dann vorteilhaft, eine Kompression oder eine Expansion vorzunehmen oder sogar eine Kombination hiervon.

Im Betrieb wird das Hörsystem in einem bestimmten Programm betrieben, welchem ein Dynamikschema zugeordnet ist. Durch das Programm ist also der Dynamikprozessor in einer vordefinierten Weise eingestellt, d.h. vorkonfiguriert. Das Programm und das Dynamikschema sind zweckmäßigerweise auf die aktuelle akustische Umgebung abgestimmt, sodass sich eine optimale Ausgabe, d.h. Ausgabequalität ergibt. Der Dynamikprozessor wird also während des Betriebs in dem einen Programm mit dem zugehörigen Dynamikschema betrieben.

Ein Kerngedanke der Erfindung besteht nun insbesondere darin, dass zumindest ein Situationsparameter ermittelt wird, welcher die aktuelle akustische Umgebung charakterisiert, d.h. insbesondere quantifiziert oder qualifiziert. Dabei wird während des Betriebs in dem einen Programm das zugeordnete Dynamikschema abhängig von dem Situationsparameter modifiziert, sodass der Dynamikprozessor mit einem modifizierten Dynamikschema betrieben wird. Das durch das Programm für die aktuelle akustische Umgebung vorgegebene Dynamikschema wird also situationsbezogen optimiert. Mit anderen Worten: das Dynamikschema für die automatische Verstärkungsregelung wird situationsabhängig modifiziert. Dem liegt die Überlegung zugrunde, dass sich die akustische Umgebung ändern kann und dadurch das gewählte Dynamikschema nicht mehr optimal ist, wobei die Änderung aber unter Umständen nicht hinreichend stark oder lang andauernd ist, um einen Wechsel des Programms, z.B. von einem Sprach- zu einem Musikprogramm, zu rechtfertigen. Ein abrupter Wechsel des Dynamikschemas wird dadurch vorteilhaft vermieden, vielmehr wird das eigentlich der Umgebung zugeordnete Dynamikschema situationsabhängig angepasst und also sozusagen im Rahmen einer Feineinstellung weiterentwickelt oder fortgebildet. Dadurch ist auf für den Nutzer angenehme Weise die Ausgabe des Hörsystems verbessert.

Vorliegend erfolgt eine Anpassung der Dynamik insbesondere nicht alleinig in Abhängigkeit des Eingangspegels oder des Ausgangspegels, vielmehr wird der automatischen Verstärkungseinheit vorzugsweise zusätzlich der Situationsparameter zugeführt und als zusätzliche Steuer- oder Regelgröße verwendet.

Der Situationsparameter wird vorzugsweise mittels eines Detektors ermittelt. Der Detektor ist vorzugsweise ein Teil des Hörsystems. In einer Alternative wird der Situationsparameter bezüglich des Hörsystems extern ermittelt und an das Hörsystem übertragen, z.B. über eine Datenverbindung.

Besonders bevorzugt ist eine Ausgestaltung, bei welcher der Dynamikprozessor ein Kompressor ist, sodass das Dynamikschema ein Kompressionsschema ist. Ebenfalls vorteilhaft ist eine Ausgestaltung, bei welcher der Dynamikprozessor ein Expander ist, sodass das Dynamikschema ein Expansionsschema ist. Ein Kompressor und ein Expander wirken typischerweise gegenläufig. Während ein Kompressor den Verstärkungsfaktor üblicherweise oberhalb eines Schwellwerts begrenzt, erhöht ein Expander üblicherweise den Verstärkungsfaktor oberhalb eines Schwellwerts. Mit anderen Worten: ein Kompressor verstärkt Signale mit geringem Pegel mehr als Signale mit demgegenüber hohem Pegel und ein Expander verstärkt umgekehrt Signale mit hohem Pegel mehr als Signale mit demgegenüber geringem Pegel. Insgesamt wird somit mit einem Kompressor die Dynamik eines Signals verringert und mit einem Kompressor wird die Dynamik eines Signals erhöht.

Vorteilhaft ist auch eine Ausgestaltung, bei welcher ein Kompressor und ein Expander miteinander kombiniert sind, entweder als zwei separate Dynamikprozessoren oder gemeinsam als ein einzelner Dynamikprozessor. In einer ersten Ausgestaltung werden der Kompressor und der Expander unabhängig voneinander verwendet, sodass immer lediglich einer von beiden aktiv ist, z.B. abhängig vom Situationsparameter oder einem eingestellten Programm des Hörsystems. In einer zweiten Ausgestaltung sind der Kompressor und der Expander dagegen gleichzeitig in einem sogenannten Hybridmodus aktiv, vorzugsweise derart, dass der Kompressor insgesamt den Pegel senkt und der Expander an einem Arbeitspunkt, d.h. in einem beschränkten Frequenz- und/oder Pegelbereich die Dynamik wieder erhöht. Mit anderen Worten: der Expander wird verwendet, um einer an sich globalen Kompression lokal entgegenzuwirken. Auch eine umgekehrte Ausgestaltung, bei welcher analog der Expander global wirkt und der Kompressor lediglich lokal, ist grundsätzlich möglich und geeignet.

In einer gegebenen Situation ist es grundsätzlich technisch möglich, entweder einen Kompressor oder eine Expander zu verwenden oder eine Kombination von beiden. Welche der drei vorgenannten Ausgestaltungen in audiologischer Hinsicht die Sinnvollste ist, hängt jedoch konkret von der Situation ab. Auch erscheint speziell eine Kombination von Kompressor und Expander zunächst zwar widersprüchlich, ist jedoch grundsätzlich technisch möglich und in manchen Situationen auch sinnvoll.

Nachfolgend wird ohne Beschränkung der Allgemeinheit davon ausgegangen, dass entweder ein Kompressor oder ein Expander verwendet wird. Die Ausführungen gelten jedoch analog auch für Ausgestaltungen in welchen sowohl ein Kompressor als auch Expander verwendet werden und in welchen sich je nach konkreter Ausgestaltung möglicherweise auch mehrere Dynamikschemata ergeben, auf welche die beschriebenen bevorzugten Ausgestaltungen dann zweckmäßigerweise jeweilig angewendet werden.

Die Modifikation innerhalb eines gegebenen Programms ist letztlich eine spezielle Anpassung des Programms selbst auf individuelle Abweichungen der aktuellen akustischen Umgebung von einer bei der Erstellung des Programms prognostizierten, idealisierten Umgebung oder auch Standardumgebung. Ein Problem beim Betrieb eines Hörsystems besteht insbesondere darin, dass in verschiedenen Umgebungen unterschiedliche Situationen gleichzeitig vorliegen, welche sich gegenseitig ausschließende Programme erfordern. Ein besonders wichtiger Fall ist das Vorhandensein von Sprache in der Umgebung. Um diese Sprache für den Nutzer maximal verständlich zu machen, wird zweckmäßigerweise ein Programm eingestellt, welches die Sprachverständlichkeit verbessert. Hierbei ist die wirklichkeitsgetreue Wiedergabe von anderen Schallsignalen oder Geräuschen von untergeordneter Bedeutung, sondern es soll vorrangig Sprache für den Nutzer erkennbar gemacht werden. Hierzu wird insbesondere ein spezielles, auf maximale Sprachverständlichkeit ausgelegtes Dynamikschema eingestellt und verwendet. Andersherum wird in einer Umgebung ohne Sprache zweckmäßigerweise eine möglichst realitätsnahe Wiedergabe der akustischen Umgebung angestrebt, es soll also eine möglichst gute Klangqualität erzielt werden. Unter möglichst guter Klangqualität wird insbesondere verstanden, dass ein Hörschaden des Nutzers möglichst optimal ausgeglichen wird, also eine maximale Hörverlustkompensation durchgeführt wird. Dies ist besonders wichtig bei Musik, welche durch ein Dynamikschema zur verbesserten Sprachverständlichkeit unter Umständen stark verzerrt wird. Gleiches gilt für andere Schallsignale in der Umgebung, welche mitunter derart stark verzerrt werden, dass diese für den Nutzer nicht mehr erkennbar sind und nicht mehr zugeordnet werden können. Zu besonderen Problemen führt dies, wenn sowohl Sprache als auch andere Schallsignale in der Umgebung vorhanden sind, wenn die akustische Umgebung also allgemein mehrere unterschiedliche Schallsignale umfasst, welchen unterschiedliche Programme zur optimalen Ausgabe zugeordnet sind, z.B. ein Sprachprogramm einerseits und ein Musikprogramm andererseits. Hier ist grundsätzlich ein Kompromiss derart möglich, dass ein Programm verwendet wird, welches nicht lediglich in einer Richtung optimiert ist, sondern vielmehr versucht, alle Schallsignale zumindest teilweise geeignet wiederzugeben. Dabei wird jedoch deutlich, dass dann keine der Schallquellen optimal ausgegeben wird, dass also mit einem solchen Programm vor allem Sprache niemals optimal verständlich ist.

Vorliegend wird dieses Problem umgangen, indem innerhalb des Programms eine Feineinstellung des Dynamikschemas erfolgt. Das Dynamikschema wird situationsabhängig modifiziert, indem zumindest ein Situationsparameter und zweckmäßigerweise mehrere Situationsparameter insbesondere wiederkehrend ermittelt wird bzw. werden, um zu gegebener Zeit eine optimale Einstellung des Dynamikprozessors zu gewährleisten. Somit erfolgt eine situationsspezifische Anpassung des Dynamikprozessors. Der Situationsparameter wird in einer geeigneten Ausgestaltung vom Hörsystem selbst ermittelt.

Insbesondere kann hierdurch vorteilhaft der oben beschriebene Zielkonflikt zwischen Sprachverständlichkeit und Klangqualität aufgelöst werden. Hierzu gibt der Situationsparameter in einer besonders vorteilhaften Ausgestaltung an, ob Sprache in der Umgebung vorhanden ist oder nicht und das Dynamikschema wird zugunsten von Sprachverständlichkeit modifiziert, falls Sprache vorhanden ist, und ansonsten zugunsten von Klangqualität. Es wird also von vornherein insbesondere ein Programm eingestellt, welches hinsichtlich einer maximalen Klangqualität optimiert ist, vorteilhafterweise ein Musikprogramm. Im Fall von Sprache wird dann die Sprachverständlichkeit priorisiert und das Programm, speziell das Dynamikschema derart modifiziert, dass sich eine maximale Sprachverständlichkeit ergibt, insbesondere ohne das eigentliche Programm zu wechseln. Die Modifikation wird dabei zweckmäßigerweise nur solange beibehalten, wie auch Sprache vorhanden ist. Die Modifikation erfolgt dabei automatisch, es wird vorteilhaft keine Nutzereingabe benötigt. Der Nutzer braucht auch nicht eine spezielles Sprachprogramm oder Klang- oder Musikprogramm auszuwählen. Es wird somit direkt auf die aktuelle akustische Umgebung reagiert, ein Umweg über eine Programmauswahl ist nicht notwendig. Das Programm ist also nicht statisch, sondern aufgrund der durchgeführten Modifikation in Abhängigkeit des Situationsparameters dynamisch. Dadurch ist gewährleistet, dass der Nutzer grundsätzlich eine maximale Klangqualität erfährt, jedoch in Situationen mit Sprache eine maximale Sprachverständlichkeit. Um zu ermitteln, ob Sprache vorhanden ist, ist der Detektor zweckmäßigerweise ein Sprachdetektor, welcher insbesondere das Eingangssignal auf das Vorhandensein von Sprache untersucht.

Das Dynamikschema definiert das Verhalten des Dynamikprozessors im Betrieb und ist definiert durch einen oder mehrere Parameter, genauer Dynamikparameter, z.B. Kompressionsparameter und/oder Expansionsparameter. Geeignete Dynamikparameter sind insbesondere ein Kompressions- oder Expansionsschwellwert, auch als Kniepunkt bezeichnet, ein Kompressions- oder Expansionsverhältnis, kurz auch als Kompression bzw. Expansion bezeichnet, eine Einschaltzeit, auch als attack bezeichnet, und eine Ausschaltzeit, auch als release bezeichnet. Die Einschaltzeit und die Ausschaltzeit des Dynamikprozessors werden auch jeweils als Zeitkonstante bezeichnet. Das Dynamikschema wird modifiziert indem die Einschaltzeit und/oder die Ausschaltzeit verändert wird.

Vorzugsweise wird also das Dynamikschema modifiziert, indem zumindest ein weiterer Parameter des Dynamikschemas verändert wird, wobei der Parameter ausgewählt ist aus einer Menge von Parametern, umfassend: ein Kniepunkt, ein Kompressionsverhältnis im Falle eines Kompressors, ein Expansionsverhältnis im Falle eines Expanders. Erfindungsgemäß wird die Einschaltzeit oder die Ausschaltzeit oder beide situationsabhangig verändert. Die übrigen Parameter sind aber auch geeignet, um das Dynamikschema zu modifizieren.

Vorliegend wird zudem in dem Programm insbesondere nicht zwischen zwei unterschiedlichen Dynamikschemata umgeschaltet, sondern es wird grundsätzlich dasselbe Dynamikschema, d.h. derselbe Dynamikalgorithmus, verwendet, dessen Parameter werden jedoch situationsabhängig angepasst, sodass das dem Dynamikschema zugrundeliegende Grundkonzept erhalten bleibt und lediglich in dessen konkreter Realisierung modifiziert wird. Dies steht im Gegensatz zur eingangs genannten DE 10 2005 061 000 A1, in welcher je nach Situation zwischen grundsätzlich unterschiedlichen Dynamikschemata umgeschaltet wird. Vorliegend wird demgegenüber dynamisch die Parametrierung des Dynamikschemas verändert.

Dynamikschemata zur Maximierung der Klangqualität und der Sprachverständlichkeit sind grundsätzlich bekannt. Für eine maximale Klangqualität wird beispielsweise eine im Ergebnis möglichst lineare Verstärkung angestrebt, sodass das Dynamikschema erst für hohe Eingangspegel eine Kompression durchführt, wohingegen für niedrige und mittlere Eingangspegel keine Kompression erfolgt und hierzu das Kompressionsverhältnis insbesondere 1 beträgt. Ein Kniepunkt, welcher den Übergang zu einem größeren Kompressionsverhältnis markiert ist dann vergleichsweise hoch angeordnet, d.h. im Vergleich zu einem Kniepunkt eines Dynamikschemas für maximale Sprachverständlichkeit. Hier wird beispielsweise derjenige Pegelbereich des Eingangssignals, welcher Sprache enthält möglichst auf den vom Nutzer hörbaren Pegelbereich abgebildet.

Der Situationsparameter ist ein Signal-zu-Rausch-Verhältnis der aktuellen akustischen Umgebung und insbesondere des Eingangssignals, sodass das Dynamikschema abhängig von dem Signal-zu-Rausch-Verhältnis der aktuellen akustischen Umgebung modifiziert wird. Das Dynamikschema wird also abhängig von der relativen Stärke von Störgeräuschen gegenüber einem Nutzsignal, also einem Schallsignal, welches der Nutzer wahrnehmen will, in der Umgebung eingestellt. Dem liegt die Überlegung zugrunde, dass bei einem hohen Signal-zu-Rausch-Verhältnis das Nutzsignal bereits hinreichend verständlich für den Nutzer ist und dann zugunsten der Klangqualität eine lediglich geringe Anpassung, speziell insbesondere eine Kompression, notwendig ist und entsprechend durchgeführt wird. Andersherum liegt bei einem geringen Signal-zu-Rausch-Verhältnis eine stark gestörte Umgebung vor, sodass das Dynamikschema speziell hierauf angepasst modifiziert wird, um das Nutzsignal gegenüber den Störsignalen zu verstärken und dadurch für den Nutzer verständlicher zu machen. Als Detektor für das Signal-zu-Rausch-Verhältnis wird zweckmäßigerweise ein Rauschdetektor verwendet, welchem insbesondere das Eingangssignal zugeführt wird, anhand dessen dann das Signal-zu-Rausch-Verhältnis der Umgebung bestimmt wird.

In der vorstehend genannten Ausgestaltung der Erfindung ist das Signal-zu-Rausch-Verhältnis ein Verhältnis aus einem Signal, welches von einem Sprecher stammt, und einem Rauschen, welches von einer oder mehrerer anderer Schallquellen in der Umgebung stammt. Die anderen Schallquellen sind beispielsweise andere Menschen, z.B. ein Publikum, oder Geräte, z.B. ein Fahrzeug, in welchem sich der Nutzer und der Sprecher befinden. Dabei weist das Dynamikschema zwei Zeitkonstanten auf, nämlich eine Einschaltzeit und eine Ausschaltzeit. Im Falle eines negativen Signal-zu-Rausch-Verhältnisses wird nun zumindest eine der Zeitkonstanten reduziert und umgekehrt wird im Falle eines positiven Signal-zu-Rausch-Verhältnisses die zumindest eine der Zeitkonstanten erhöht. Unter "eine Zeitkonstante wird reduziert" wird verstanden, dass eine schnelle Zeitkonstante eingestellt wird. Unter "eine Zeitkonstante wird erhöht" wird entsprechend verstanden, dass eine langsame Zeitkonstante eingestellt wird. Allgemein wird in Bezug auf die Einschaltzeit unter "schnell" eine Zeit von bis zu 10 ms verstanden und unter "langsam" eine Zeit von 100 ms bis 1 s. In Bezug auf die Ausschaltzeit wird allgemein unter "schnell" eine Zeit von bis zu 100 ms verstanden und unter "langsam" eine Zeit von 500 ms bis 1 s.

Vorzugsweise werden im Falle eines negativen Signal-zu-Rausch-Verhältnisses beide Zeitkonstanten reduziert und umgekehrt werden im Falle eines positiven Signal-zu-Rausch-Verhältnisses dann auch beide Zeitkonstanten erhöht. Dem liegt die Überlegung zugrunde, dass Umgebungen mit einem negativen Signal-zu-Rausch-Verhältnis für den Nutzer sehr anstrengend sind. Der Nutzer profitiert in einer solchen Situation insbesondere von Lücken im Eingangssignal, d.h. von kurzen Zeitabschnitten, in welchen das Rauschen sehr gering ist, wobei unter kurz insbesondere eine Länge von höchstens einer Sekunde verstanden wird. Diese Lücken werden zweckmäßigerweise durch die situationsabhängige Modifikation des Dynamikschemas mit entsprechend schnellen Zeitkonstanten verstärkt. Unter schnell wird in diesem Zusammenhang insbesondere eine Zeitkonstante von höchstens 100ms verstanden. Dieses Vorgehen verbessert die Sprachverständlichkeit bei starkem Rauschen, führt aber zu einer schlechteren Klangqualität, weshalb bei entsprechend geringem Rauschen auf dieses Vorgehen verzichtet wird und stattdessen vergleichsweise lange Zeitkonstanten gewählt werden, insbesondere Zeitkonstanten von länger als 100ms, sodass die Anpassung, speziell insbesondere die Kompression, insgesamt schwächer ist.

In einer weiteren vorteilhaften Ausgestaltung ist ein weiterer Situationsparameter eine Umgebungsklasse, sodass das Dynamikschema abhängig von der Umgebungsklasse modifiziert wird, wobei die Umgebungsklasse insbesondere ausgewählt ist aus einer Menge von Klassen, umfassend: Sprache, Musik, Störgeräusch. Der Situationsparameter wird hierbei insbesondere mittels eines Detektors ermittelt, welcher als Klassifikator ausgebildet ist. Der Klassifikator ist zweckmäßigerweise ein Teil der Signalverarbeitung und bestimmt die Umgebungsklasse insbesondere anhand des Eingangssignals. Ist die Umgebungsklasse Musik, wird das Dynamikschema eher konservativ modifiziert, d.h. es wird beispielsweise bei einer Kompression weniger komprimiert als z.B. bei Sprache. Bei Sprache wird das Dynamikschema dann auf eine maximale Sprachverständlichkeit hin modifiziert. Dies findet vorteilhafte Anwendung bei einem Konzert oder ähnlichen Umgebungen, in denen keine Sprache vorhanden ist. Das Dynamikschema wird dann hinsichtlich einer möglichst wirklichkeitsgetreuen Wiedergabe von Musik, Rhythmen und Melodien modifiziert, also wird also insbesondere eine im Ergebnis für den Nutzer möglichst lineare Verstärkung angestrebt.

In einer weiteren vorteilhaften Ausgestaltung ist ein weiterer Situationsparameter ein Bewegungsmuster, sodass das Dynamikschema abhängig von einer Bewegung des Hörsystems modifiziert wird, wobei das Bewegungsmuster insbesondere ausgewählt ist aus einer Menge von Bewegungsmustern, umfassend: eine Ruheposition, eine Gehbewegung, eine Laufbewegung, eine Fahrt. Das Bewegungsmuster wird insbesondere mittels eines Detektors ermittelt, welcher als ein Bewegungssensor ausgebildet ist, vorzugsweise mittels eines Beschleunigungssensors. Hierbei wird insbesondere unterschieden zwischen Bewegung und Ruhe. Die Bewegung wird zweckmäßigerweise weiter unterteilt in verschiedene Arten der Bewegung, z.B. der Geschwindigkeit nach. Beispielsweise wird erkannt, ob der Nutzer still steht, geht oder in einem Auto fährt. Dem liegt der Gedanke zugrunde, dass allgemein in unterschiedlichen Umgebungssituationen die Sprachverständlichkeit unterschiedlich wichtig ist und daher das Dynamikschema zweckmäßigerweise abhängig vom bewegungszustand oder -verhalten des Nutzers modifiziert wird.

In einer weiteren vorteilhaften Ausgestaltung ist ein weiterer Situationsparameter eine Stationarität der aktuellen akustischen Umgebung und insbesondere des Eingangssignals, sodass das Dynamikschema abhängig von der Stationarität der aktuellen akustischen Umgebung modifiziert wird. Zur Ermittlung der Stationarität wird zweckmäßigerweise ein Stationaritätsdetektor verwendet, welchem insbesondere das Eingangssignal zugeführt wird, anhand dessen dann die Stationarität ermittelt wird. Die Stationarität ist insbesondere ein Maß für die Dynamik einer oder mehrerer Schallquellen der Umgebung, d.h. ein Maß für die zeitliche Änderung des Pegels dieser Schalquelle oder Schallquellen. Die Stationarität gibt also die Dynamik des zeitabhängigen Pegels an.

In einer weiteren vorteilhaften Ausgestaltung ist ein weiterer Situationsparameter eine Diffusheit der aktuellen akustischen Umgebung, sodass das Dynamikschema abhängig von der Diffusheit der aktuellen akustischen Umgebung modifiziert wird. Zur Ermittlung der Diffusheit wird zweckmäßigerweise ein Diffusheitsdetektor verwendet, welchem insbesondere das Eingangssignal zugeführt wird, anhand dessen dann die Diffusheit ermittelt wird. Die Diffusheit ist der oben beschriebenen Stationarität insofern ähnlich, als dass die Diffusheit ein Maß für eine Variation des Pegels in der Umgebung ist, nun aber nicht zeitabhängig, sondern ortsabhängig. Die Diffusheit gibt also an, wie gerichtet die Umgebung ist, ob also Schallsignale aus einer bestimmten Richtung auf den Nutzer zu kommen, also gerichtet, oder gleichmäßig aus allen Richtungen, also diffus. Die Diffusheit gibt also die Dynamik des richtungsabhängigen Pegels an. Ein räumlich sehr homogener Pegel führt also zu einer hohen Diffusheit.

In einer weiteren vorteilhaften Ausgestaltung ist ein weiterer Situationsparameter eine Entfernung des Hörsystems, insbesondere eines ggf. vorhandenen Mikrofons zu einer Schallquelle, insbesondere zu einem Sprecher, in der aktuellen akustischen Umgebung, sodass das Dynamikschema abhängig von der Entfernung modifiziert wird. Die Entfernung wird insbesondere mittels eines Entfernungsmessers als Detektor ermittelt. Da das Hörsystem vom Nutzer getragen wird entspricht die Entfernung zwischen Hörsystem und Schallquelle auch der Entfernung zwischen Nutzer und Schallquelle. Dem liegt die Überlegung zugrunde, dass weiter entfernte Schallquellen üblicherweise schlechter verständlich sind und daher das Dynamikschema in diesem Fall zweckdienlicherweise für eine höhere Sprachverständlichkeit modifiziert wird.

In einer weiteren vorteilhaften Ausgestaltung ist ein weiterer Situationsparameter eine Nachhallzeit der aktuellen akustischen Umgebung, sodass das Dynamikschema abhängig von der Nachhallzeit modifiziert wird, wobei das Dynamikschema zwei Zeitkonstanten aufweist, nämlich eine Einschaltzeit und eine Ausschaltzeit, wobei die Nachhallzeit wiederkehrend ermittelt wird und im Falle einer Vergrößerung der Nachhallzeit die zumindest eine der Zeitkonstanten erhöht wird und umgekehrt im Falle einer Verringerung der Nachhallzeit reduziert wird. Dem liegt der Gedanke zugrunde, dass in Umgebungen mit starkem Hall eine schnelle Anpassung, speziell insbesondere eine schnelle Kompression, insgesamt also kurze Zeitkonstanten eher nachteilig sind. Die Nachhallzeit wird zweckmäßigerweise mittels eines Detektors ermittelt, welchem das Eingangssignal zugeführt wird, sodass der Detektor die Nachhallzeit anhand einer Analyse des Eingangssignals bestimmt.

Besonders vorteilhaft ist auch eine Kombination der oben beschriebenen unterschiedlichen Konzepte. In einer zweckmäßigen Ausgestaltung werden dann mehrere Situationsparameter ermittelt und zur Steuerung der automatischen Verstärkungsregelung verwendet. In einer geeigneten Ausgestaltung wird der gleiche Situationsparameter mittels mehrerer gleichartiger oder unterschiedliche Detektoren redundant ermittelt.

In einer weiteren vorteilhaften Ausgestaltung ist das eine Programm ein Universalprogramm. Das Universalprogramm zeichnet sich insbesondere dadurch aus, dass dieses nicht auf eine spezielle, vordefinierte Situation angepasst ist oder in einem bestimmten, begrenzten Anwendungsbereich verwendet wird, sondern in mehreren unterschiedlichen Situationen verwendet wird. In einer geeigneten Ausgestaltung wird das Hörsystem ausschließlich mittels des einen Programms betrieben, sodass also auf eine Ausgestaltung mit unterschiedlichen Programmen, welche jeweils speziell auf unterschiedliche Umgebungen angepasst und optimiert sind, verzichtet wird. Stattdessen erfolgt eine Anpassung an eine veränderte akustische Umgebung alleinig auf dem Weg des situationsabhängig modifizierten Dynamikschemas. In einer ebenfalls geeigneten Ausgestaltung weist das Hörgerät zusätzlich zum Universalprogramm noch ein oder mehrere Spezialprogramme auf, welche jeweils für spezielle, konkrete Situationen angepasst sind. Vorzugsweise ist ein jeweiliges Spezialprogramm vom Nutzer einstellbar und wird vorzugsweise nicht automatisch eingestellt. Während die Spezialprogramme unveränderlich sind, d.h. für je eine bestimmte Situation feste und vorbestimmte Parameterwerte speziell für das Dynamikschema aber auch allgemein vorgeben, ist das Universalprogramm variabel, wenigstens aufgrund des situationsangepassten Dynamikschemas. Das Universalprogramm wird daher allgemein auch als Automatikprogramm bezeichnet, da sich dieses automatisch an die Umgebung anpasst, während die einzelnen Spezialprogramme im Gegensatz hierzu statisch sind. Der Situationsparameter wird beim Universalprogramm insbesondere direkt der automatischen Verstärkungsregelung zugeführt und zur Steuerung des Verstärkungsfaktors verwendet. Vorzugsweise wird hierbei auch auf die Möglichkeit einer manuellen Verstärkungseinstellung verzichtet. Eine manuelle Anpassung durch den Nutzer ist geeigneterweise lediglich durch die Auswahl eines Spezialprogramms möglich. Alle Anpassungen werden ausgehend von dem Universalprogramm automatisch und situationsabhängig durchgeführt, indem das Dynamikschema in Abhängigkeit des Situationsparameters modifiziert wird.

In einer anderen Ausgestaltung der Erfindung wird das Dynamikschema frequenzabhängig modifiziert. Darunter wird insbesondere verstanden, dass situationsabhängig für unterschiedliche Frequenzen ein oder mehrere Parameter des Dynamikschemas unterschiedlich verändert wird bzw. werden. Das Eingangssignal weist ein Frequenzspektrum auf, welches nun in wenigstens zwei Frequenzbereiche aufgeteilt ist. Ein Frequenzbereich ist insbesondere eine einzelne Frequenz oder ein Frequenzintervall. Zweckmäßigerweise wird das Eingangssignal mittels einer Filterbank der Signalverarbeitung in mehrere aufeinanderfolgende Frequenzbereiche aufgeteilt. Die Frequenzbereiche überlappen vorzugsweise nicht, abgesehen von einem möglicherweise technisch bedingten, geringfügigen Überlapp im Randbereich. Abhängig vom Situationsparameter wird das Dynamikschema nun nicht lediglich für das gesamte Frequenzspektrum auf die gleiche Weise modifiziert, sondern speziell für die einzelnen Frequenzbereiche. Das zuvor beschriebene Verfahren, bei welchem das Dynamikschema modifiziert wird, wird somit sozusagen parallel in mehreren Frequenzbereichen durchgeführt. Dadurch lässt sich insbesondere eine weiter verbesserte Kompression oder Expansion erzielen. Besonders vorteilhaft ist, dass das Dynamikschema gezielt für bestimmte Frequenzbereiche modifiziert wird, sodass eine optimale Anpassung an die aktuelle akustische Umgebung gewährleistet ist. Die frequenzabhängige Modifikation des Dynamikschemas ist für alle beschriebenen Situationsparameter geeignet. Grundsätzlich geeignet ist auch eine Ausgestaltung, bei welcher in verschiedenen Frequenzbereichen je nach Bedarf eine Kompression oder eine Expansion durchgeführt wird oder beides in Kombination.

Der Parameter, welcher zur Modifikation des Dynamikschemas verändert wird, wird bei der frequenzabhängigen Modifikation demnach in unterschiedlichen Frequenzbereichen situationsabhängig unterschiedlich verändert. Gemäß der alternativen Ausgestaltung wird das Dynamikschema erfindungsgemäß modifiziert, indem die Einschaltzeit des Dynamikschemas oder die Ausschaltzeit des Dynamikschemas oder beide frequenzabhängig verändert werden. Mit anderen Worten: die Einschaltzeit oder die Ausschaltzeit oder beide Parameter werden für unterschiedliche Frequenzbereiche unabhängig voneinander verändert, sodass sich gegebenenfalls für unterschiedliche Frequenzbereiche auch unterschiedliche Zeitkonstanten ergeben. Dadurch werden gezielt bestimmte Frequenzbereiche hinsichtlich der Zeitkonstante modifiziert, ohne dieselbe Modifikation auch für alle anderen Frequenzbereiche durchzuführen.

In der vorstehend genannten, anderen Ausgestaltung der Erfindung wird zwischen Sprachfrequenzbereichen und sprachfreien Frequenzbereichen unterschieden, d.h. zwischen Frequenzbereichen, welche Sprache enthalten, und Frequenzbereichen, welche keine Sprache enthalten. Ein geeigneter Sprachfrequenzbereich ist ein Frequenzbereich von 800 Hz bis 4 kHz oder eine Teilmenge davon. Geeignete sprachfreie Frequenzbereiche sind entsprechend Frequenzbereiche unterhalb von 800 Hz und oberhalb von 4 kHz. Alternativ erfolgt eine detailliertere Aufteilung des Frequenzspektrums bei welcher die Sprachfrequenzbereiche einzelnen Lauten oder Formanten entsprechen und alle übrigen Frequenzen dann sprachfreie Frequenzbereiche bilden. Ein Parameter des Dynamikschemas wird frequenzabhängig verändert, indem der Parameter auf einem jeweiligen Frequenzbereich abhängig davon eingestellt wird, ob dieser Frequenzbereich ein Sprachfrequenzbereich ist oder ein sprachfreier Frequenzbereich. Die frequenzabhängige Modifikation entspricht demnach einer sprachabhängigen Modifikation. Insgesamt werden dadurch vorteilhaft die Sprachfrequenzbereiche gegenüber den sprachfreien Frequenzbereichen diskriminiert und für beide Arten von Frequenzbereich wird das Dynamikschema jeweils optimal modifiziert. Dadurch ergibt sich insbesondere eine verbesserte Sprachverständlichkeit. Auch die sprachabhängige Modifikation des Dynamikschemas ist für alle beschriebenen Situationsparameter geeignet.

In der vorstehend genannten, anderen Ausgestaltung der Erfindung erfolgt eine Kombination der sprachabhängigen Modifikation mit der bereits genannten Ausgestaltung, bei welcher der Situationsparameter ein Signal-zu-Rausch-Verhältnis der aktuellen akustischen Umgebung und insbesondere des Eingangssignals ist. Im Falle eines negativen Signal-zu-Rausch-Verhältnisses wird auf einem Sprachfrequenzbereich zumindest eine der Zeitkonstanten des Dynamikschemas wie bereits beschrieben reduziert und umgekehrt im Falle eines positiven Signal-zu-Rausch-Verhältnisses die zumindest eine Zeitkonstante erhöht. Auf einem sprachfreien Frequenzbereich wird vorliegend dann umgekehrt im Falle eines negativen Signal-zu-Rausch-Verhältnisses die zumindest eine Zeitkonstante erhöht und im Falle eines positiven Signal-zu-Rausch-Verhältnisses die zumindest eine Zeitkonstante reduziert. Die Zeitkonstante ist vorzugsweise die Ausschaltzeit. Unter "eine Zeitkonstante wird reduziert" wird vorzugsweise verstanden, dass eine schnelle Zeitkonstante eingestellt wird. Unter "eine Zeitkonstante wird erhöht" wird entsprechend vorzugsweise verstanden, dass eine langsame Zeitkonstante eingestellt wird.

Alternativ oder zusätzlich zur frequenzabhängigen Änderung der Zeitkonstanten ist auch eine Ausgestaltung möglich, bei welcher ein anderer Parameter des Dynamikschemas frequenzabhängig modifiziert wird, z.B. werden ein Kompressions- oder Expansionsverhältnis oder ein jeweiliger Kniepunkt in unterschiedlichen Frequenzbereichen unabhängig voneinander und dadurch gegebenenfalls unterschiedlich verändert.

Das erfindungsgemäße Hörsystem weist eine Signalverarbeitung auf, welche ausgebildet ist zur Durchführung eines Verfahrens wie vorstehend beschrieben. Weiterhin weist das Hörsystem einen Hörer auf, zur Ausgabe eines Ausgangssignals.

Vorzugsweise ist das Hörsystem als Hörgerät ausgebildet und weist ein oder mehrere Mikrofone auf, zur Erzeugung des Eingangssignals. Das Hörgerät ist beispielsweise ein BTE-, ITE- oder RIC-Gerät. Das Hörgerät weist ein Gehäuse auf, in welchem das Mikrofon untergebracht ist. Vorzugsweise ist in dem Gehäuse auch die Signalverarbeitung angeordnet. Zweckmäßigerweise ist in dem Gehäuse eine Batterie angeordnet, zur Energieversorgung des Hörgeräts. Der Hörer ist entweder in dem Gehäuse untergebracht oder über eine Zuleitung, insbesondere ein Kabel, mit dem Gehäuse verbunden. Das Hörgerät ist entweder monaural ausgebildet, mit nur einem einzigen Gehäuse, oder binaural, mit zwei Gehäusen, welche jeweils ein oder mehrere Mikrofone aufweisen und welche jeweils einen

Hörer aufweisen oder mit einem solchen verbunden sind. Die Gehäuse des binauralen Hörgeräts werden dann auf unterschiedlichen Seiten des Kopfes des Nutzers getragen.

Das Vorhandensein eines Mikrofons ist bei dem Hörsystem nicht zwingend, sodass in einer geeigneten Ausgestaltung das Hörsystem kein Mikrofon aufweist und z.B. als ein Kopfhörer ausgebildet ist.

Nachfolgend wird ein Ausführungsbeispiel der Erfindung anhand einer Zeichnung näher erläutert. Darin zeigen jeweils schematisch:
- Fig. 1: ein Hörsystem,
- Fig. 2: ein Blockschaltbild des Hörsystems,
- Fig. 3: eine frequenzabhängige Modifikation eines Parameters eines Dynamikschemas.

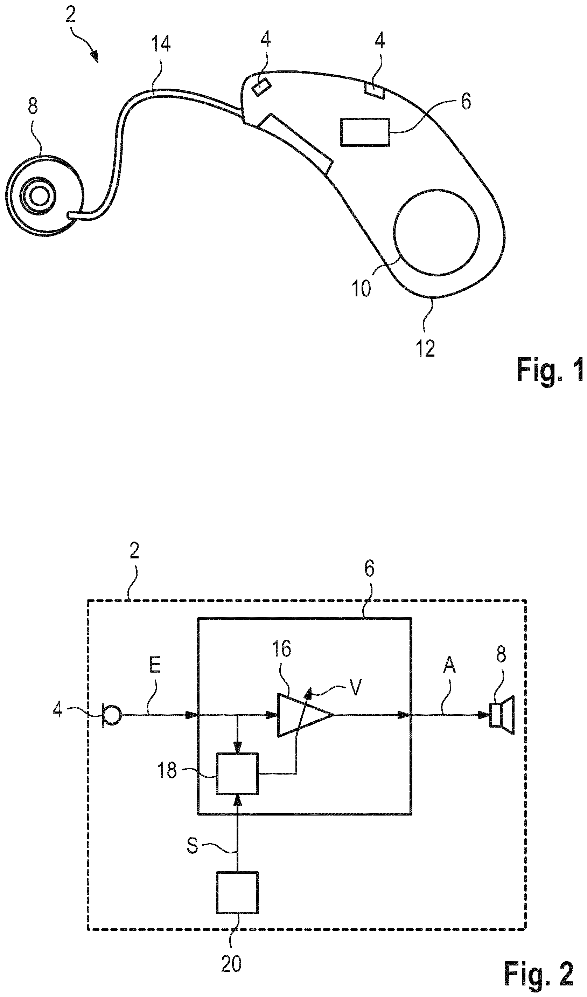

Fig. 1 zeigt ein Hörsystem 2, welches vorliegend als ein Hörgerät ausgebildet ist, genauer als ein RIC-Gerät, welches von einem insbesondere hörgeschädigten Nutzer hinter dem Ohr getragen wird. Als Hörgerät weist das Hörsystem 2 im Ausführungsbeispiel ein oder mehrere und hier zwei Mikrofone 4 auf, zur Erzeugung eines Eingangssignals E aus Schallsignalen aus der Umgebung. Das Vorhandensein eines Mikrofons 4 ist jedoch nicht zwingend, sodass in einer Variante das Hörsystem 2 kein Mikrofon aufweist und z.B. ein Kopfhörer ist. Weiter weist das Hörsystem 2 eine Signalverarbeitung 6 und einen Hörer 8 auf sowie zur Energieversorgung und eine Batterie 10 auf. Das Hörsystem 2 weist vorliegend zudem ein Gehäuse 12 auf, in welchem die Mikrofone 4, die Signalverarbeitung 6 und die Batterie 10 angeordnet sind. Der Hörer 8 ist über eine Zuleitung 14 mit dem Gehäuse verbunden und in Fig. 1 in ein Ohrstück integriert, welches in das Ohr des Nutzers eingeführt wird.

Im Betrieb wandeln die Mikrofone 4 die Schallsignale in der Umgebung in ein Eingangssignal E um, welches der Signalverarbeitung 6 zugeführt wird und durch diese modifiziert wird. Auf diese Weise wird durch die Signalverarbeitung 6 ein Ausgangssignal A erzeugt, welches also ein modifiziertes Eingangssignal E ist. Vorliegend wird das Eingangssignal E mit einem bestimmten Verstärkungsfaktor V verstärkt. Das Ausgangssignal A, also das verstärkte Eingangssignal E wird schließlich mittels des Hörers 8 an den Nutzer ausgegeben. Bei dem Eingangssignal E und dem Ausgangssignal A handelt es sich jeweils um elektrische Signale. Der Hörer 8 wandelt dann das Ausgangssignal A in ein Schallsignal um.

Das Hörsystem 2 ist entweder monaural ausgebildet oder binaural. Ein binaurales Hörsystem 2 weist dann beispielsweise zwei Gehäuse 12 mit den zugehörigen Komponenten wie in Fig. 1 gezeigt auf, wobei die Signalverarbeitung 6 nicht in beiden Fällen identisch sein muss.

In Fig. 2 ist das Hörsystem 2 als ein Blockschaltbild gezeigt. Die Signalverarbeitung 6 weist einen Verstärker 16 auf, welchem das Eingangssignal E zugeführt wird und welcher dieses dann verstärkt und als Ausgangssignal A an den Hörer 8 weitergibt. Die Verstärkung im Verstärker 16 erfolgt mit einem Verstärkungsfaktor V, welcher durch eine automatische Verstärkungsregelung eingestellt wird. Diese weist hierzu einen Dynamikprozessor 18 auf. Das Hörsystem 2 wird nun in einem Programm betrieben, welchem ein bestimmtes Dynamikschema zugeordnet ist, mit welchem der Dynamikprozessor 18 während des Betriebs in dem einen Programm betrieben wird. Das jeweilige Dynamikschema definiert den Verstärkungsfaktor V als Funktion eines Pegels des Eingangssignals E. Die Funktion ist durch diverse Parameter charakterisiert, vorliegend z.B. durch einen oder mehrere Kniepunkte, ein oder mehrere Kompressions- oder Expansionsverhältnisse, eine Einschaltzeit (attack), eine Ausschaltzeit (release) oder eine Kombination hiervon.

Der Dynamikprozessor 18 ist vorliegend entweder ein Kompressor oder ein Expander oder eine Kombination hiervon. In einem nicht gezeigten Ausführungsbeispiel sind zwei Dynamikprozessoren 18 vorhanden, von welchen der eine ein Kompressor ist und der andere ein Expander, wobei dann die Ausführungen zu dem gezeigten Ausführungsbeispiel analog gelten.

Zusätzlich wird ein Situationsparameter S ermittelt, welcher die aktuelle akustische Umgebung charakterisiert und welcher dann während des Betriebs in dem einen Programm genutzt wird, um das zugeordnete Dynamikschema zu modifizieren. Der Dynamikprozessor 18 wird dann abhängig von dem Situationsparameter S mit einem modifizierten Dynamikschema betrieben. Zur Ermittlung des Situationsparameters S in ein Detektor 20 angeordnet, welcher hier ein Teil des Hörsystems 2 ist. Der Detektor 20 ist allgemein mit der Signaleinheit 6 und speziell mit der automatischen Verstärkungsregelung verbunden, hier konkret mit dem Dynamikprozessor 18.

Der Detektor 20 ist beispielsweise ein Sprachdetektor, welcher ermittelt, ob Sprache in der Umgebung vorhanden ist. Alternativ ermittelt der Detektor 20 als Situationsparameter S ein Signal-zu-Rausch-Verhältnis in der Umgebung. Hierzu wird in einer geeigneten Ausführung das Eingangssignal E dem Detektor 20 zugeführt, sodass dieser als Situationsparameter S das Signal-zu-Rausch-Verhältnis des Eingangssignals E ermittelt. Alternativ ist der Detektor 20 ein Klassifikator, welcher beispielsweise anhand des Eingangssignals E die Umgebung einer bestimmten Umgebungsklasse zuordnet. Alternativ ist der Detektor 20 ein Bewegungsdetektor, beispielsweise ein Beschleunigungssensor, welcher ein Bewegungsmuster als Situationsparameter S ermittelt. Der Bewegungsdetektor ermittelt beispielsweise, ob sich der Nutzer bewegt oder nicht oder wie schnell sich der Nutzer bewegt oder in welche Richtung oder eine Kombination hiervon. Alternativ ist der Detektor 20 ein Stationaritätsdetektor, welcher die Stationarität der Umgebung ermittelt, d.h. wie zeitliche Dynamik der Schallsignale der Umgebung. Hierzu wird dem Detektor 20 beispielsweise das Eingangssignal E zugeführt, dessen Stationarität, also dessen zeitliche Veränderung der Detektor 20 dann ermittelt und als Situationsparameter S ausgibt. Alternativ ist der Detektor 20 ein Diffusheitsdetektor, welcher die Diffusheit der Umgebung ermittelt, d.h. wie räumliche Verteilung der Schallsignale in der Umgebung. Hierzu wird dem Detektor 20 beispielsweise das Eingangssignal E zugeführt, dessen Gerichtetheit, also dessen räumliche Pegelverteilung der Detektor 20 dann ermittelt und als Situationsparameter S ausgibt. Alternativ ist der Detektor 20 ein Entfernungsmesser, welcher die Entfernung des Hörsystems 2 zu einer Schallquelle in der Umgebung bestimmt und diese Entfernung dann als Situationsparameter S ausgibt. Alternativ ermittelt der Detektor 20 die Nachhallzeit in der Umgebung, z.B. anhand einer Analyse des Eingangssignals E. In einer nicht gezeigten Variante sind mehrere gleiche oder verschiedene der oben genannten Detektoren 20 kombiniert.

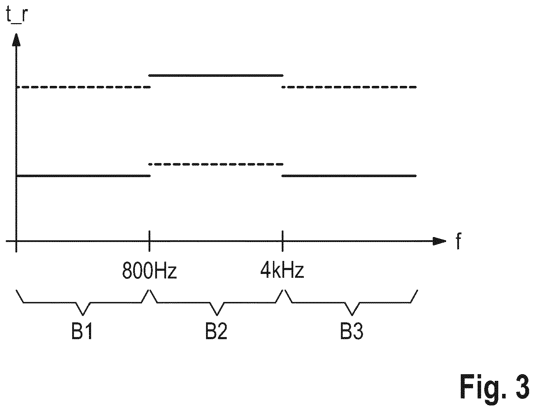

In Fig. 3 ist ein Ausführungsbeispiel für eine frequenzabhängige Modifikation des Dynamikschemas gezeigt. Dabei wird situationsabhängig für unterschiedliche Frequenzen f ein Parameter des Dynamikschemas unterschiedlich verändert. Das Eingangssignal E weist ein Frequenzspektrum auf, welches in hier drei Frequenzbereiche B1 - B3 aufgeteilt ist. Abhängig vom Situationsparameter S wird das Dynamikschema nun nicht lediglich für das gesamte Frequenzspektrum auf die gleiche Weise modifiziert, sondern speziell für die einzelnen Frequenzbereiche B1 - B3. Das zuvor beschriebene Verfahren, bei welchem das Dynamikschema modifiziert wird, wird somit sozusagen in den Frequenzbereichen B1 - B3 parallel durchgeführt. Im gezeigten Ausführungsbeispiel wird die Ausschaltzeit t_r des Dynamikschemas frequenzabhängig verändert. Dabei wird zusätzlich zwischen Sprachfrequenzbereichen B2, hier von 800 Hz bis 4 kHz, und sprachfreien Frequenzbereichen B1, B3, hier unterhalb von 800 Hz und oberhalb von 4 kHz, unterschieden. In einer nicht gezeigten Variante erfolgt eine detailliertere Aufteilung des Frequenzspektrums, bei welcher die Sprachfrequenzbereiche einzelnen Lauten oder Formanten entsprechen und alle übrigen Frequenzen dann sprachfreie Frequenzbereiche bilden.

Die Ausschaltzeit t_r und allgemein ein Parameter des Dynamikschemas, wird vorliegend frequenzabhängig verändert, indem diese auf einem jeweiligen Frequenzbereich B1 - B3 abhängig davon eingestellt wird, ob dieser Frequenzbereich B1 - B3 ein Sprachfrequenzbereich B2 ist oder ein sprachfreier Frequenzbereich B1, B3. Die frequenzabhängige Modifikation entspricht demnach einer sprachabhängigen Modifikation. In Fig. 3 ist dies kombiniert mit einer Ausgestaltung, bei welcher der Situationsparameter S ein Signal-zu-Rausch-Verhältnis der aktuellen akustischen Umgebung ist. Die frequenzabhängige Ausschaltzeit t_r im Falle eines positiven Signal-zu-Rausch-Verhältnisses ist in Fig. 3 durch durchgezogenen Linien gezeigt und im Falle eines negativen Signal-zu-Rausch-Verhältnisses durch gestrichene Linien. Im Falle eines negativen Signal-zu-Rausch-Verhältnisses wird auf dem Sprachfrequenzbereich B2 die Ausschaltzeit t_r reduziert und umgekehrt wird im Falle eines positiven Signal-zu-Rausch-Verhältnisses die Ausschaltzeit t_r erhöht. Auf den sprachfreien Frequenzbereichen B1, B3 wird dagegen umgekehrt im Falle eines negativen Signal-zu-Rausch-Verhältnisses die Ausschaltzeit t_r erhöht und im Falle eines positiven Signal-zu-Rausch-Verhältnisses die Ausschaltzeit t_r reduziert. Dabei wird unter "reduziert" verstanden, dass eine schnelle Ausschaltzeit t_r eingestellt wird und unter "erhöht" wird verstanden, dass eine langsame Ausschaltzeit t_r eingestellt wird. Dasselbe Vorgehen ist aber auch für die Einschaltzeit grundsätzlich geeignet.

Alternativ oder zusätzlich zur frequenzabhängigen Änderung der Zeitkonstanten ist auch eine Ausgestaltung geeignet, bei welcher ein anderer Parameter des Dynamikschemas frequenzabhängig modifiziert wird, z.B. werden ein Kompressions- oder Expansionsverhältnis oder ein jeweiliger Kniepunkt in unterschiedlichen Frequenzbereichen unabhängig voneinander und dadurch gegebenenfalls unterschiedlich verändert.

### Bezugszeichenliste

2 Hörsystem
4 Mikrofon
6 Signalverarbeitung
8 Hörer
10 Batterie
12 Gehäuse
14 Zuleitung
16 Verstärker
18 Dynamikprozessor
20 Detektor
A Ausgangssignal
B1, B3 sprachfreier Frequenzbereich
B2 Sprachfrequenzbereich
E Eingangssignal
S Situationsparameter
t_r Ausschaltzeit
V Verstärkungsfaktor

## Patentansprüche

1. Verfahren zum Betrieb eines Hörsystems (2) in einer aktuellen akustischen Umgebung,
- wobei das Hörsystem (2) eine Signalverarbeitung (6) aufweist,
- wobei die Signalverarbeitung (6) aus einem Eingangssignal (E) ein Ausgangssignal (A) erzeugt, indem das Eingangssignal (E) mit einem Verstärkungsfaktor (V) verstärkt wird,
- wobei das Hörsystem (2) einen Hörer (8) aufweist, über welchen das Ausgangssignal (A) ausgegeben wird,
- wobei der Verstärkungsfaktor (V) durch eine automatische Verstärkungsregelung eingestellt wird, welche einen Dynamikprozessor (18) aufweist, welcher mit einem Dynamikschema betreibbar ist, welches den Verstärkungsfaktor (V) als Funktion eines Pegels des Eingangssignals (E) definiert,
- wobei das Hörsystem (2) in einem Programm betrieben wird, welchem ein Dynamikschema zugeordnet ist, mit welchem der Dynamikprozessor (18) während des Betriebs in dem einen Programm betrieben wird,
- wobei zumindest ein Situationsparameter (S) ermittelt wird, welcher die aktuelle akustische Umgebung charakterisiert,
- wobei während des Betriebs in dem einen Programm das zugeordnete Dynamikschema abhängig von dem Situationsparameter (S) modifiziert wird, sodass der Dynamikprozessor (18) mit einem modifizierten Dynamikschema betrieben wird,
**dadurch gekennzeichnet,**
- **dass** der Situationsparameter (S) ein Signal-zu-Rausch-Verhältnis der aktuellen akustischen Umgebung ist, sodass das Dynamikschema abhängig von dem Signal-zu-Rausch-Verhältnis der aktuellen akustischen Umgebung modifiziert wird,
- **dass** das Signal-zu-Rausch-Verhältnis ein Verhältnis ist aus einem Signal, welches von einem Sprecher stammt, und einem Rauschen, welches von einer oder mehrerer anderer Schallquellen stammt,
- **dass** das Dynamikschema zwei Zeitkonstanten aufweist, nämlich eine Einschaltzeit und eine Ausschaltzeit,
- **dass** im Falle eines negativen Signal-zu-Rausch-Verhältnisses zumindest eine der Zeitkonstanten reduziert wird und umgekehrt im Falle eines positiven Signal-zu-Rausch-Verhältnisses die zumindest eine der Zeitkonstanten erhöht wird.

2. Verfahren zum Betrieb eines Hörsystems (2) in einer aktuellen akustischen Umgebung,
- wobei das Hörsystem (2) eine Signalverarbeitung (6) aufweist,
- wobei die Signalverarbeitung (6) aus einem Eingangssignal (E) ein Ausgangssignal (A) erzeugt, indem das Eingangssignal (E) mit einem Verstärkungsfaktor (V) verstärkt wird,
- wobei das Hörsystem (2) einen Hörer (8) aufweist, über welchen das Ausgangssignal (A) ausgegeben wird,
- wobei der Verstärkungsfaktor (V) durch eine automatische Verstärkungsregelung eingestellt wird, welche einen Dynamikprozessor (18) aufweist, welcher mit einem Dynamikschema betreibbar ist, welches den Verstärkungsfaktor (V) als Funktion eines Pegels des Eingangssignals (E) definiert,
- wobei das Hörsystem (2) in einem Programm betrieben wird, welchem ein Dynamikschema zugeordnet ist, mit welchem der Dynamikprozessor (18) während des Betriebs in dem einen Programm betrieben wird,
- wobei zumindest ein Situationsparameter (S) ermittelt wird, welcher die aktuelle akustische Umgebung charakterisiert,
- wobei während des Betriebs in dem einen Programm das zugeordnete Dynamikschema abhängig von dem Situationsparameter (S) modifiziert wird, sodass der Dynamikprozessor (18) mit einem modifizierten Dynamikschema betrieben wird,
**dadurch gekennzeichnet,**
- **dass** zwischen Sprachfrequenzbereichen (B2) und sprachfreien Frequenzbereichen (B1, B3) unterschieden wird,
- **dass** ein Parameter des Dynamikschemas frequenzabhängig verändert wird, indem der Parameter auf einem jeweiligen Frequenzbereich (B1, B2, B3) abhängig davon eingestellt wird, ob dieser Frequenzbereich (B1, B2, B3) ein Sprachfrequenzbereich (B2) ist oder ein sprachfreier Frequenzbereich (B1, B3),
- **dass** der Situationsparameter (S) ein Signal-zu-Rausch-Verhältnis der aktuellen akustischen Umgebung ist,
- **dass** das Dynamikschema zwei Zeitkonstanten aufweist, nämlich eine Einschaltzeit und eine Ausschaltzeit,
- **dass** im Falle eines negativen Signal-zu-Rausch-Verhältnisses auf einem Sprachfrequenzbereich (B2) zumindest eine der Zeitkonstanten reduziert wird und im Falle eines positiven Signal-zu-Rausch-Verhältnisses die zumindest eine Zeitkonstante erhöht wird,
- **dass** auf einem sprachfreien Frequenzbereich (B1, B3) im Falle eines negativen Signal-zu-Rausch-Verhältnisses die zumindest eine Zeitkonstante erhöht wird und im Falle eines positiven Signal-zu-Rausch-Verhältnisses die zumindest eine Zeitkonstante reduziert wird.

3. Verfahren nach Anspruch 2,
wobei das Dynamikschema modifiziert wird, indem eine Einschaltzeit des Dynamikschemas oder eine Ausschaltzeit (t_r) des Dynamikschemas oder beide frequenzabhängig verändert werden

4. Verfahren nach einem der Ansprüche 1 bis 3,
wobei der Dynamikprozessor (18) ein Kompressor ist, sodass das Dynamikschema ein Kompressionsschema ist.

5. Verfahren nach einem der Ansprüche 1 bis 4,
wobei der Dynamikprozessor (18) ein Expander ist, sodass das Dynamikschema ein Expansionsschema ist.

6. Verfahren nach einem der Ansprüche 1 bis 5,
- wobei der Situationsparameter (S) angibt, ob Sprache in der Umgebung vorhanden ist oder nicht,
- wobei das Dynamikschema zugunsten von Sprachverständlichkeit modifiziert wird, falls Sprache vorhanden ist, und ansonsten zugunsten von Klangqualität.

7. Verfahren nach einem der Ansprüche 1 bis 6,
- wobei das Dynamikschema modifiziert wird, indem zumindest ein Parameter des Dynamikschemas verändert wird,
- wobei der Parameter ausgewählt ist aus einer Menge von Parametern, umfassend: eine Einschaltzeit, eine Ausschaltzeit (t_r), ein Kniepunkt, ein Kompressionsverhältnis, ein Expansionsverhältnis.

8. Verfahren nach einem der Ansprüche 1 bis 7,
- wobei der Situationsparameter (S) eine Umgebungsklasse ist, sodass das Dynamikschema abhängig von der Umgebungsklasse modifiziert wird,
- wobei die Umgebungsklasse insbesondere ausgewählt ist aus einer Menge von Klassen, umfassen: Sprache, Musik, Störgeräusch.

9. Verfahren nach einem der Ansprüche 1 bis 8,
- wobei der Situationsparameter (S) ein Bewegungsmuster ist, sodass das Dynamikschema abhängig von einer Bewegung des Hörsystems (2) modifiziert wird,
- wobei das Bewegungsmuster insbesondere ausgewählt ist aus einer Menge von Bewegungsmustern, umfassend: eine Ruheposition, eine Gehbewegung, eine Laufbewegung, eine Fahrt.

10. Verfahren nach einem der Ansprüche 1 bis 9,
wobei der Situationsparameter (S) eine Stationarität der aktuellen akustischen Umgebung und insbesondere des Eingangssignals ist, sodass das Dynamikschema abhängig von der Stationarität der aktuellen akustischen Umgebung modifiziert wird.

11. Verfahren nach einem der Ansprüche 1 bis 10,
wobei der Situationsparameter (S) eine Diffusheit der aktuellen akustischen Umgebung ist, sodass das Dynamikschema abhängig von der Diffusheit der aktuellen akustischen Umgebung modifiziert wird,
wobei die Diffusheit ein Maß für eine Variation des Pegels in der Umgebung ist.

12. Verfahren nach einem der Ansprüche 1 bis 11,
wobei der Situationsparameter (S) eine Entfernung des Hörsystems (2) zu einer Schallquelle, insbesondere zu einem Sprecher, in der aktuellen akustischen Umgebung ist, sodass das Dynamikschema abhängig von der Entfernung modifiziert wird.

13. Verfahren nach einem der Ansprüche 1 bis 12,
- wobei der Situationsparameter (S) eine Nachhallzeit der aktuellen akustischen Umgebung ist, sodass das Dynamikschema abhängig von der Nachhallzeit modifiziert wird,
- wobei das Dynamikschema zwei Zeitkonstanten aufweist, nämlich eine Einschaltzeit und eine Ausschaltzeit,
- wobei die Nachhallzeit wiederkehrend ermittelt wird und im Falle einer Vergrößerung der Nachhallzeit die zumindest eine der Zeitkonstanten erhöht wird und umgekehrt im Falle einer Verringerung der Nachhallzeit reduziert wird.

14. Hörsystem (2), aufweisend:
- eine Signalverarbeitung (6), welche ausgebildet ist zur Durchführung eines Verfahrens nach einem der Ansprüche 1 bis 13,
- einen Hörer (8), zur Ausgabe eines Ausgangssignals (A).

## Claims

1. Method for operating a hearing aid system (2) in a current acoustic environment,
- wherein the hearing aid system (2) comprises a signal processor (6),
- wherein the signal processor (6) generates an output signal (A) from an input signal (E) by amplifying the input signal (E) by a gain factor (V),
- wherein the hearing aid system (2) has a receiver (8), via which the output signal (A) is output,
- wherein the gain factor (V) is set by an automatic gain control, which has a dynamic range processor (18) that can be operated with a dynamic range scheme which defines the gain factor (V) as a function of a level of the input signal (E),
- wherein the hearing aid system (2) is operated in a program to which a dynamic range scheme is assigned, with which the dynamic range processor (18) is operated during operation in the program,
- wherein at least one situation parameter (S) is determined, which characterizes the current acoustic environment,
- wherein during operation in the program, the assigned dynamic range scheme is modified depending on the situation parameter (S), so that the dynamic range processor (18) is operated with a modified dynamic range scheme,
**characterized**
- **in that** the situation parameter (S) is a signal-to-noise ratio of the current acoustic environment, so that the dynamic range scheme is modified depending on the signal-to-noise ratio of the current acoustic environment,
- **in that** the signal-to-noise ratio is a ratio of a signal which originates from a speaker and a noise which originates from one or more other sound sources,
- **in that** the dynamic range scheme has two time constants, namely a switch-on time and a switch-off time,
- **in that** in the case of a negative signal-to-noise ratio at least one of the time constants is reduced and conversely, in the case of a positive signal-to-noise ratio the at least one of the time constants is increased.

2. Method for operating a hearing aid system (2) in a current acoustic environment,
- wherein the hearing aid system (2) comprises a signal processor (6),
- wherein the signal processor (6) generates an output signal (A) from an input signal (E) by amplifying the input signal (E) by a gain factor (V),
- wherein the hearing aid system (2) has a receiver (8), via which the output signal (A) is output,
- wherein the gain factor (V) is set by an automatic gain control, which has a dynamic range processor (18) that can be operated with a dynamic range scheme which defines the gain factor (V) as a function of a level of the input signal (E),
- wherein the hearing aid system (2) is operated in a program to which a dynamic range scheme is assigned, with which the dynamic range processor (18) is operated during operation in the program,
- wherein at least one situation parameter (S) is determined, which characterizes the current acoustic environment,
- wherein during operation in the program, the assigned dynamic range scheme is modified depending on the situation parameter (S), so that the dynamic range processor (18) is operated with a modified dynamic range scheme,
**characterized**
- **in that** a distinction is made between speech frequency bands (B2) and speech-free frequency bands (B1, B3),
- **in that** a parameter of the dynamic range scheme is changed as a function of frequency by setting the parameter over a particular frequency band (B1, B2, B3) according to whether this frequency band (B1, B2, B3) is a speech frequency band (B2) or a speech-free frequency band (B1, B3),
- **in that** the situation parameter (S) is a signal-to-noise ratio of the current acoustic environment,
- **in that** the dynamic range scheme has two time constants, namely a switch-on time and a switch-off time,
- **in that** in the case of a negative signal-to-noise ratio over a speech frequency band (B2) at least one of the time constants is reduced and in the case of a positive signal-to-noise ratio the at least one time constant is increased,
- **in that** over a speech-free frequency band (B1, B3), in the case of a negative signal-to-noise ratio the at least one time constant is increased and in the case of a positive signal-to-noise ratio the at least one time constant is reduced.

3. Method according to Claim 2,
wherein the dynamic range scheme is modified by changing a switch-on time of the dynamic range scheme or a switch-off time (t_r) of the dynamic range system, or both, as a function of frequency.

4. Method according to any one of Claims 1 to 3,
wherein the dynamic range processor (18) is a compressor, so that the dynamic range scheme is a compression scheme.

5. Method according to any one of Claims 1 to 4,
wherein the dynamic range processor (18) is an expander, so that the dynamic range scheme is an expansion scheme.

6. Method according to any one of Claims 1 to 5,
- wherein the situation parameter (S) indicates whether speech is present in the environment or not,
- wherein the dynamic range scheme is modified in favor of speech intelligibility if speech is present, and otherwise in favor of sound quality.

7. Method according to any one of Claims 1 to 6,
- wherein the dynamic range scheme is modified by changing at least one parameter of the dynamic range scheme,
- wherein the parameter is selected from a set of parameters comprising: a switch-on time, a switch-off time (t_r), a knee point, a compression ratio, an expansion ratio.

8. Method according to any one of Claims 1 to 7,
- wherein the situation parameter (S) is an environment class, so that the dynamic range scheme is modified depending on the environment class,
- wherein the environment class is in particular selected from a set of classes, comprising: speech, music, noise.

9. Method according to any one of Claims 1 to 8,
- wherein the situation parameter (S) is a motion pattern, so that the dynamic range scheme is modified depending on a motion of the hearing aid system (2),
- wherein the motion pattern is selected in particular from a set of motion patterns, comprising: a resting position, a walking motion, a running motion, driving.

10. Method according to any one of Claims 1 to 9,
wherein the situation parameter (S) is a stationarity of the current acoustic environment and in particular of the input signal, so that the dynamic range scheme is modified depending on the stationarity of the current acoustic environment.

11. Method according to any one of Claims 1 to 10,
wherein the situation parameter (S) is a diffuseness of the current acoustic environment, so that the dynamic range scheme is modified depending on the diffuseness of the current acoustic environment,
wherein the diffuseness is a measure of a variation in the level in the environment.

12. Method according to any one of Claims 1 to 11,
wherein the situation parameter (S) is a distance from the hearing aid system (2) to a sound source, in particular a speaker, in the current acoustic environment, so that the dynamic range scheme is modified depending on the distance.

13. Method according to any one of Claims 1 to 12,
- wherein the situation parameter (S) is a reverberation time of the current acoustic environment, so that the dynamic range scheme is modified depending on the reverberation time,
- wherein the dynamic range scheme has two time constants, namely a switch-on time and a switch-off time,
- wherein the reverberation time is determined on a recurring basis and in the event of an increase in the reverberation time at least one of the time constants is increased and conversely reduced in the event of a decrease in the reverberation time.

14. Hearing aid system (2), comprising:
- a signal processor (6), which is designed to carry out a method according to any one of Claims 1 to 13,
- a receiver (8) for outputting an output signal (A).

## Revendications

1. Procédé de fonctionnement d'un système auditif (2) dans un environnement acoustique actuel,
- le système auditif (2) comportant un traitement de signal (6),
- le traitement de signal (6) générant un signal de sortie (A) à partir d'un signal d'entrée (E) par amplification du signal d'entrée (E) avec un facteur d'amplification (V),
- le système auditif (2) comportant un écouteur (8) qui délivre le signal de sortie (A),
- le facteur d'amplification (V) étant réglé par une régulation d'amplification automatique qui comporte un processeur de dynamique (18) qui peut fonctionner avec un schéma de dynamique qui définit le facteur d'amplification (V) en fonction d'un niveau du signal d'entrée (E),
- le système auditif (2) fonctionnant dans un programme auquel est associé un schéma de dynamique permettant de faire fonctionner le processeur de dynamique (18) pendant le fonctionnement dans l'un des programmes,
- au moins un paramètre de situation (S) étant déterminé qui caractérise l'environnement acoustique actuel,
- pendant le fonctionnement dans un programme, le schéma de dynamique associé étant modifié en fonction du paramètre de situation (S), de sorte que le processeur de dynamique (18) fonctionne avec un schéma de dynamique modifié,
**caractérisé en ce que**
- le paramètre de situation (S) est un rapport signal sur bruit de l'environnement acoustique actuel, de sorte que le schéma de dynamique est modifié en fonction du rapport signal sur bruit de l'environnement acoustique actuel,
- le rapport signal sur bruit est le rapport d'un signal provenant d'un haut-parleur et d'un bruit provenant d'une ou plusieurs autres sources acoustiques,
- le schéma de dynamique comportant deux constantes de temps, à savoir un temps d'activation et un temps de désactivation,
- dans le cas d'un rapport signal sur bruit négatif, au moins une des constantes de temps est réduite et, à l'inverse, dans le cas d'un rapport signal sur bruit positif, au moins une des constantes de temps est augmentée.

2. Procédé de fonctionnement d'un système auditif (2) dans un environnement acoustique actuel,
- le système auditif (2) comportant un traitement de signal (6),
- le traitement de signal (6) générant un signal de sortie (A) à partir d'un signal d'entrée (E) par amplification du signal d'entrée (E) avec un facteur d'amplification (V),
- le système auditif (2) comportant un écouteur (8) qui délivre le signal de sortie (A),
- le facteur d'amplification (V) étant réglé par une régulation d'amplification automatique qui comporte un processeur de dynamique (18) qui peut fonctionner avec un schéma de dynamique qui définit le facteur d'amplification (V) en fonction d'un niveau du signal d'entrée (E),
- le système auditif (2) fonctionnant dans un programme auquel est associé un schéma de dynamique permettant de faire fonctionner le processeur de dynamique (18) pendant le fonctionnement dans l'un des programmes,
- au moins un paramètre de situation (S) étant déterminé qui caractérise l'environnement acoustique actuel,
- pendant le fonctionnement dans un programme, le schéma de dynamique associé étant modifié en fonction du paramètre de situation (S), de sorte que le processeur de dynamique (18) fonctionne avec un schéma de dynamique modifié,
**caractérisé en ce que**
- une distinction est faite entre les zones de fréquences avec son vocal (B2) et les zones de fréquences sans son vocal (B1, B3),
- un paramètre du schéma de dynamique est modifié en fonction de la fréquence par réglage du paramètre sur une zone de fréquences respective (B1, B2, B3) selon que cette zone de fréquences (B1, B2, B3) est ou non une zone de fréquences avec son vocal (B2) ou une zone de fréquences sans son vocal (B1, B3),
- le paramètre de situation (S) est un rapport signal sur bruit de l'environnement acoustique actuel,
- le schéma de dynamique comporte deux constantes de temps, à savoir un temps d'activation et un temps de désactivation,
- dans le cas d'un rapport signal sur bruit négatif dans une zone de fréquences avec son vocal (B2), au moins une des constantes de temps est réduite et dans le cas d'un rapport signal sur bruit positif, l'au moins une constante de temps est augmentée,
- dans une zone de fréquences sans son vocal (B1, B3), en cas de rapport signal sur bruit négatif, l'au moins une constante de temps est augmentée et en cas de rapport signal sur bruit positif, l'au moins une constante de temps est réduite.

3. Procédé selon la revendication 2,
le schéma de dynamique étant modifié par modification d'un temps d'activation du schéma de dynamique ou d'un temps de désactivation (t_r) du schéma de dynamique ou les deux selon la fréquence.

4. Procédé selon l'une des revendications 1 à 3,
le processeur de dynamique (18) étant un compresseur, de sorte que le schéma de dynamique est un schéma de compression.

5. Procédé selon l'une des revendications 1 à 4,
le processeur de dynamique (18) étant un expanseur, de sorte que le schéma de dynamique est un schéma d'expansion.

6. Procédé selon l'une des revendications 1 à 5,
- le paramètre de situation (S) indiquant si un son vocal est présent ou non dans l'environnement,
- le schéma de dynamique étant modifié en faveur de l'intelligibilité du son vocal si le son vocal est présent et sinon en faveur de la qualité sonore.

7. Procédé selon l'une des revendications 1 à 6,
- le schéma de dynamique étant modifié par modification d'au moins un paramètre du schéma de dynamique,
- le paramètre étant sélectionné parmi un ensemble de paramètres comprenant : un temps d'activation, un temps de désactivation (t_r), un point d'inflexion, un rapport de compression, un rapport d'expansion.

8. Procédé selon l'une des revendications 1 à 7,
- le paramètre de situation (S) étant une classe d'environnement, de sorte que le schéma de dynamique est modifié en fonction de la classe d'environnement,
- la classe d'environnement étant notamment choisie parmi un ensemble de classes comprenant : un son vocal, de la musique, un bruit.

9. Procédé selon l'une des revendications 1 à 8,
- le paramètre de situation (S) étant un modèle de mouvement, de sorte que le schéma de dynamique est modifié en fonction d'un mouvement du système auditif (2),
- le modèle de mouvement étant notamment choisi parmi un ensemble de modèles de mouvement comprenant : une position de repos, un mouvement de marche, un mouvement de course, un parcours en véhicule.

10. Procédé selon l'une des revendications 1 à 9,
le paramètre de situation (S) étant une stationnarité de l'environnement acoustique actuel et notamment du signal d'entrée, de sorte que le schéma de dynamique est modifié en fonction de la stationnarité de l'environnement acoustique actuel.

11. Procédé selon l'une des revendications 1 à 10,
le paramètre de situation (S) étant une diffusivité de l'environnement acoustique actuel, de sorte que le schéma de dynamique soit modifié en fonction de la diffusivité de l'environnement acoustique actuel,
la diffusivité étant une mesure d'une variation du niveau dans l'environnement.

12. Procédé selon l'une des revendications 1 à 11,
le paramètre de situation (S) étant une distance du système auditif (2) à une source acoustique, en particulier à un locuteur, dans l'environnement acoustique actuel, de sorte que le schéma de dynamique soit modifié en fonction de la distance.

13. Procédé selon l'une des revendications 1 à 12,
- le paramètre de situation (S) étant un temps de réverbération de l'environnement acoustique actuel, de sorte que le schéma de dynamique soit modifié en fonction du temps de réverbération,
- le schéma de dynamique comportant deux constantes de temps, à savoir un temps d'activation et un temps de désactivation,
- le temps de réverbération étant déterminé de manière répétée et l'au moins une des constantes de temps étant augmentée en cas d'augmentation du temps de réverbération et, à l'inverse, étant réduite en cas de réduction du temps de réverbération.

14. Système auditif (2), comportant :
- un traitement de signal (6) conçu pour mettre en œuvre un procédé selon l'une des revendications 1 à 13,
- un écouteur (8) destiné à délivrer un signal de sortie (A).
